# EUROPEAN PATENT APPLICATION

(11) **EP 1 348 483 A1**
(43) Date of publication of application: **01.10.2003**
(21) Application number: 01978866.0
(22) Date of filing: 24.10.2001
(51) Int. Cl.: B01J 19/12, B08B 7/00, C23C 16/455, H01L 21/302

(54) **EXCIMER UV PHOTO REACTOR**

(30) Priority: 01.11.2000 JP 2000334726; 29.03.2001 JP 2001096288; 27.04.2001 JP 2001130842; 26.06.2001 JP 2001193060
(71) Applicant: SHIN-ETSU ENGINEERING Co., Ltd., Tokyo 101-0054 (JP)
(72) Inventor: OHNODA, Tadatomo, SHIN-ETSU ENGINEERING CO., LTD, Tokyo 101-0054 (JP); SAKAI, Ikuo, SHIN-ETSU ENGINEERING CO., LTD, Tokyo 101-0054 (JP)
(74) Representative: Wood, Graham
(86) International application number: JP0109314
(87) International publication number: WO02036259

(57) **Abstract**

A reactant gas (C) is supplied from a reactant gas supply means (1) concentratedly to active areas (A1) alone on a target article (A) , a photochemical reaction between excimer UV and the reactant gas (C) is thereby accelerated in a low-temperature atmosphere. The reactant gas (C) is not supplied to areas (A2), where the photochemical reaction does not actively occur, and is not wasted. A reactant gas source having a large gas-supply capability is not required. The photochemical reaction can be stably performed with a simple structure in a low-temperature atmosphere.

## Description

### Technical Field

The present invention relates to an excimer UV photo reactor. Such excimer UV photo reactors are used as excimer UV-ozone cleaning devices (dry cleaning devices) for removing organic-compound contaminants attached to, for example, glass substrates of liquid crystal displays and surfaces of silicon semiconductor wafers; as ashing devices for removing unnecessary photoresists on silicon wafers in processes for the fabrication of semiconductors by a photochemical reaction with ozone gas; as hydrogen annealing devices for increasing the crystal integrity of surfaces of silicon wafers by a photochemical reaction with hydrogen gas; and as metallorganic (MO) chemical vapor deposition (CVD) systems for the formation of metal films on silicon wafers by a photochemical reaction with a gas of a vaporized organometallic compound.

More specifically, it relates to an excimer UV photo reactor which includes plural excimer UV lamps arrayed in parallel and facing a target article and is capable of applying excimer UV from these excimer UV lamps to the target article in an atmosphere of a reactant gas to thereby allow a photochemical reaction to occur on a surface of the target article.

### Background Art

Conventional excimer UV photo reactors include a device as disclosed in, for example, Japanese Patent No. 2705023. The device includes a housing of an irradiation device having an output window made of a synthetic quartz glass and plural excimer UV lamps (dielectric barrier discharge lamps) arrayed in parallel in the housing, and nitrogen gas is supplied into the housing. Excimer UV (vacuum ultra-violet) radiated from the excimer UV lamps is applied through the output window to a surface of a target article (an object) to thereby form ozone and active oxidizing decomposition products around the target article by a photochemical reaction, and the ozone and active oxidizing decomposition products are brought into contact with the target article to thereby oxidize the target article.

The present applicant has made an experiment using the irradiation device, in which a photochemical reaction was performed in a low-temperature atmosphere at or around ordinary temperature while excimer UV was applied from the excimer UV lamps disposed in parallel to a target article and ozone was supplied as a reactive gas into an enclosed space housing the irradiation device and the target article.

The results of the experiment show that the photochemical reaction occurred to some extent in narrow areas on a surface of the target article directly below the individual excimer UV lamps, but its reactivity gradually decreased with an increasing distance from the areas and attained the minimum in are as directly be low the boundaries between adjacent excimer UV lamps.

This is probably for the following reasons. In the surface of the target article, the narrow areas directly below the excimer UV lamps are in the shortest distance from the excimer UV lamps with large radiant exposure and can receive a required amount of light energy to thereby allow the photochemical reaction to occur to a sufficient extent. However, with an increasing distance from the active areas, the distance from the excimer UV lamps gradually increases and the excimer UV applied thereto is absorbed by oxygen surrounding the target article to form ozone and is decreased. Accordingly, the areas distant from the areas directly below the excimer UV lamps fail to receive light energy to a required extent and the photochemical reaction fails to occur to a sufficient extent.

However, these conventional excimer UV photo reactors often fail to increase the reactive gas to a required concentration in the vicinity of the surface of the target article to thereby fail to allow a stable photochemical reaction to rapidly occur in a low-temperature atmosphere (e.g., at ordinary temperature). In addition, the ozone layer increases in thickness to increase absorption of UV light to thereby fail to yield sufficient reaction effects.

As a possible solution to the problems, a large amount of the reactant gas can be continuously supplied from a reactant gas source such as an ozone generator to the enclosed space to thereby increase the concentration of the reactant gas in the vicinity of the surface of the target article. However, this system requires a reactant gas source having an extremely large gas-supply capability and thereby invites markedly increased production cost.

When the output window is upsized with an increasing size of the target article, the system must have an upsized synthetic quartz glass for the output window and invites increased production cost.

The conventional excimer UV-ozone cleaning device cannot efficiently clean an entire target article having a large area, since the degree of cleaning in the target article after cleaning distinctly differs between the active areas directly below the excimer UV lamps and the distant areas.

When the output window is upsized with an increasing size of the target article, the enclosed space between the target article and the output window has an increased area. To supply a gas required for the reaction to the large enclosed space, the reactant gas must be supplied in one direction from one of sides of the target article facing each other to the other, and it takes a long time to completely supply and replace the gas. Accordingly, contaminant derivatives formed as a result of oxidation and removal of the organic contaminants keep on being suspended in the enclosed space, and the suspended contaminant derivatives readily attach to the output window.

In addition, recent studies have revealed that excessive photon energy causes a great reaction damage in an area where an excimer UV-induced photochemical reaction occurs to thereby keep the area active even after the excimer UV-induced photochemical reaction, and as a result, contaminants in the air are attracted and attach to the area after the reaction.

Accordingly, an object of the invention according to claim 1 is to perform a stable photochemical reaction with a simple structure in a lower-temperature atmosphere.

An object of the invention according to claim 2 is to promptly introduce a reactant gas into a reaction area to thereby replace the atmosphere, in addition to the object of the invention according to claim 1.

It is an object of the invention according to claim 3 to effectively use excimer UV which has not contributed to cleaning and to thereby clean the target article more efficiently.

An object of the invention according to claim 4 is to suppress activation after a reaction treatment with excimer UV to thereby stabilize the system so as to be resistant to the attachment of contaminants after the reaction treatment, in addition to the object of the invention according to claim 3.

An object of the invention according to claim 5 is to keep an appropriate distance between electrodes of the excimer UV lamps and the target article while protecting the electrodes, in addition to the object of the invention according to any one of claims 1, 2, 3, and 4.

An object of the invention according to claim 6 is to clean the target article further more efficiently while preventing the contaminant derivatives formed as a result of the cleaning procedure from attaching to or around a protecting tube, in addition to the object of the invention according to claim 5.

It is an object of the invention according to claim 7 to shorten a reaction time while avoiding unevenness in the photochemical reaction, in addition to the object of the invention according to any one of claims 1, 2, 3, and 4.

### Disclosure of Invention

To achieve the above objects, the present invention provides, as the invention according to claim 1, an excimer UV photo reactor further comprising reactant gas supply means in the vicinity of a surface of a target article, the reactant gas supply means being capable of forcedly supplying the reactant gas to active areas on the target article irradiated with the excimer UV at a high exposure.

The term "reactant gas" as used herein means and includes gases that can yield a photochemical reaction with excimer UV of 172 nm applied from an excimer UV lamp, such as ozone gas, hydrogen gas, and gases of vaporized metallorganic compounds.

The operation of the invention according to claim 1 derived from the configuration is that the photochemical reaction between excimer UV and the reactant gas is accelerated in a low-temperature atmosphere by focussing and supplying the reactant gas from the reactant gas supply means concentratedly to the active areas alone on the target article , and that the photo reactor does not require a reactant gas source having a large gas-supply capability, since the reactant gas is not supplied to areas where the photochemical reaction does not occur actively and is not wasted.

The present invention also provides, as the invention according to claim 2, an excimer UV photo reactor further comprising a reaction auxiliary gas supply means in addition to the configuration of the invention according to claim 1, the reaction auxiliary gas supply means being more distant from the target article than the reactant gas supply means and being capable of forcedly supplying a reaction auxiliary gas to the target article.

The term "reaction auxiliary gas" as used herein means and includes carrier gases such as nitrogen gas and inert gases (argon, helium, and others).

The operation of the invention according to claim 2 derived from the configuration is that a space except the active areas to which the reactant gas is supplied is filled with the reaction auxiliary gas and that unnecessary gas in the reaction is rapidly exhausted from the reaction areas.

The present invention further provides, as the invention according to claim 3, an excimer UV photo reactor further comprising pairs of optically transparent walls being highly transparent to the excimer UV, each pair of optically transparent walls being sandwiched between two of excimer UV lamps and partitioning and constituting a passage, wherein the excimer UV photo reactor further comprising supply means at an inlet of each passage, the supply means being capable of forcedly supplying appropriate amounts of a reaction auxiliary gas and oxygen, and wherein the excimer UV photo reactor is capable of forcing ozone formed in each passage from an outlet thereof to the target article so that an atmosphere becomes rich in ozone, the atmosphere being in the vicinity of areas being irradiated with the excimer UV at a low exposure and being distant from areas directly below the excimer UV lamps.

The operation of the invention according to claim 3 derived from the aforementioned configuration is as follows. The excimer UV is applied from the excimer UV lamps through the optically transparent walls into each passage and reacts with oxygen to form ozone without being absorbed by the reaction auxiliary gas in the passage. The ozone increases to a high concentration during its moving to the outlet of the passage and is forced through the outlet to the target article to thereby make an atmosphere rich in ozone, the atmosphere being in the vicinity of areas with a low radiant exposure of the excimer UV distant from areas directly below the excimer UV lamps. By this configuration, the areas in question receive a sufficient quantity of light energy to oxidize and remove organic contaminants.

An excimer UV photo reactor of the invention according to claim 4 further comprises humidifying means for supplying water molecules or hydrogen in addition to the reaction auxiliary gas and oxygen, in addition to the configuration of the invention according to claim 3.

The operation of the invention according to claim 4 derived from this configuration is as follows. The ozone (O₃) formed by action of the excimer UV and water molecules (H₂O) or hydrogen (H₂) are further decomposed, the decomposed products react with each other to form [•OH] radicals in large amounts, these [•OH] radicals are combined with the activated surface of the target article after the reaction treatment with the excimer UV to further effectively modify the surface of the reaction area to thereby improve wettability notably.

The present invention further provides , as the invention according to claim 5, an excimer UV photo reactor in which the optically transparent walls are protecting tubes surrounding outer periphery of each excimer UV lamp, and nitrogen gas is supplied into between the excimer UV lamp and the protecting tube, in addition to the configuration of the invention according to any one of claims 1, 2, 3, and 4.

The operation of the invention according to claim 5 derived from this configuration is as follows. By covering the outer peripheries of the excimer UV lamps with the protecting tubes, the electrodes of the excimer UV lamps are prevented from direct contact with activated oxygen and from forming oxides. In addition, the excimer UV is prevented from being absorbed in a space between the tube walls of the lamps to the outside of the protecting tubes to thereby prevent the light intensity from decreasing.

The invention according to claim 6 further comprises suction means for sucking the ozone and the reaction auxiliary gas from an atmosphere in the vicinity of the target article and forcedly exhausting the gases, in addition to the configuration of the invention according to claim 5.

The operation of the invention according to claim 6 derived from this configuration is as follows. The ozone and the reaction auxiliary gas in an atmosphere in the vicinity of the target article after cleaning have contributed to oxidation and removal of organic contaminants, are sucked from the vicinity of the target article and are forcedly exhausted without delay. Contaminant derivatives formed as a result of oxidation and removal of the organic contaminants are thereby rapidly exhausted together, and, with exhaustion, fresh ozone and reaction auxiliary gas are sequentially supplied from the outlets of the passages to thereby further accelerate the oxidation and removal of the organic contaminants.

The invention according to claim 7 further comprises transport means for relatively moving one of the excimer UV lamps and the target article to the other while maintaining the distance between the two, in addition to the configuration of the invention according to any one of claims 1, 2, 3, and 4.

The operation of the invention according to claim 7 derived from this configuration is as follows. By relatively moving the excimer UV lamps and the target article, the entire target article passes directly below the excimer UV lamps. Unevenness in exposure of the excimer UV is thereby minimized, and the irradiation time of the excimer UV to irradiate the entire surface of the target article is shortened.

### Brief Description of the Drawings

Fig. 1 is an elevational view partly in vertical section of an excimer UV photo reactor as an embodiment of the present invention.
Fig. 2 is an elevational view partly in vertical section of an excimer UV photo reactor as a modified embodiment of the present invention.
Fig. 3 is an elevational view partly in vertical section of an excimer UV photo reactor as another modified embodiment of the present invention.
Fig. 4 is an elevational view partly in vertical section of an excimer UV photo reactor as another embodiment of the present invention.
Fig. 5 is a schematic diagram of a humidifying means.
Fig. 6 is a schematic plan view in transverse section.
Fig. 7 is an elevational view partly in vertical section of an excimer UV photo reactor as a modified embodiment of the present invention.
Fig. 8 is an elevational view partly in vertical section of an excimer UV photo reactor as another modified embodiment of-the present invention.

### Best Mode for Carrying Out the Invention

Several embodiments of the present invention will be illustrated with reference to the attached drawings.

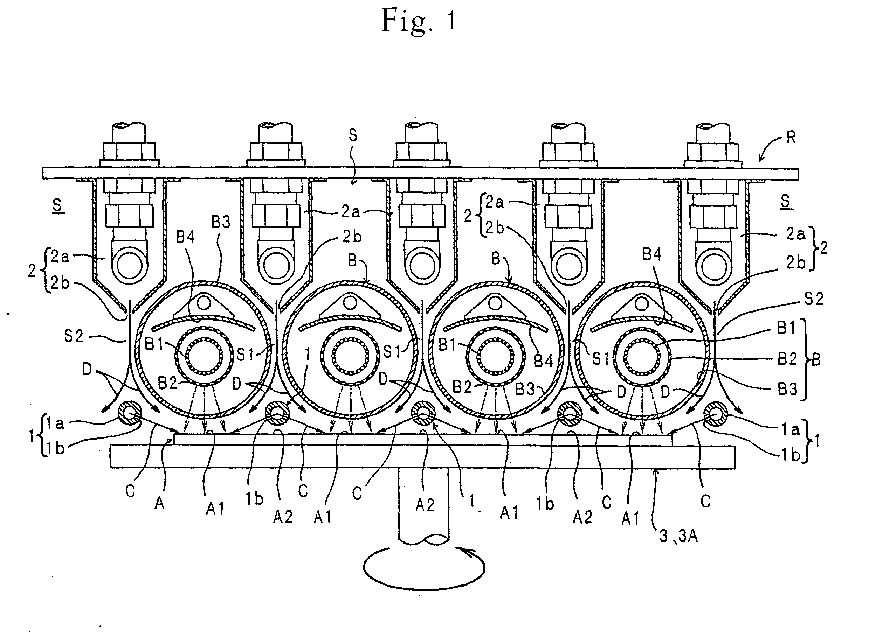

With reference to Fig. 1, an excimer UV photo reactor R as an embodiment of the present has plural excimer UV lamps B ... which face a target article A and are arrayed in parallel in a space S inside the excimer UV photo reactor R. Each of the excimer UV lamps B has a dual cylindrical structure and a transparent protecting tube B3 covering the outside of the dual cylindrical structure. The dual cylindrical structure comprises a mesh cylindrical inner electrode B1 and a mesh cylindrical outer electrode B2 arrayed coaxially outside the inner electrode B1 and radially emits excimer UV of 172 nm.

The protecting tube B3 is in the form of a hollow cylinder made of a material having satisfactory transparency to excimer UV, such as a synthetic quartz glass, and is disposed coaxially outside the outer electrode B2 of each excimer UV lamp B.

Nitrogen gas is supplied into between the outer electrode B2 and the protecting tube B3 to avoid absorption of the excimer UV and decay of light energy to thereby prevent oxidation of the outer electrode B2 and the inner electrode Bl. Where necessary, a reflector B4 may be disposed so that excimer light emitted to the backside of each excimer UV lamp B is reflected to the target article A.

The target article A is, for example, a silicon semiconductor wafer or a glass substrate of a liquid crystal display. In the embodiment shown in the figure, the target article A is a large-diameter silicon semiconductor wafer having a diameter of about 200 mm or more.

Narrow areas A1 ... on the surface of the target article A directly below and along the parallel excimer UV lamps B ... receive the excimer UV at a higher exposure than the other areas A2 ... and are highly active . To forcedly supply a reactant gas C to these active areas A1 ..., reactant gas supply means 1 ... are arranged in the vicinity of the surface of the target article A.

In the present embodiment, these reactant gas supply means 1 ... comprise plural gas inlet tubes 1a ... and a multitude of nozzle orifices 1b .... The gas inlet tubes 1a ... are disposed substantially in parallel with the individual excimer UV lamps B ... so that they do not cause interference with the excimer UV applied from the excimer UV lamps B ... to the active areas A1 .... The nozzle orifices 1b ... are arranged in the outer peripheries of the gas inlet tubes 1a ... at appropriate intervals in an axial direction toward the active areas A1 ... on the target article A.

In the embodiment shown in the figure, each gas inlet tube 1a is disposed between two of the parallel excimer UV lamps B ... and at both ends thereof. Among them, the gas inlet tubes 1a ... disposed between two of the excimer UV lamps B ... have the nozzle orifices 1b ... arranged in the shape of a sector in section toward the adjacent active areas A1 and A1 directly below the excimer UV lamps B ..., and the reactant gas C is separately supplied from the gas inlet tubes 1a ...through the nozzle orifices 1b ....

A source (not shown) of the reactant gas C is connected at the upper ends of these gas inlet tubes 1a ..., and the reactant gas C supplied from the reactant gas source is blown through the individual nozzle orifice 1b ... to the active areas A1 ... on the target article A.

The reactant gas C differs depending on the intended purpose of the excimer UV photo reactor R.

For example, when the excimer UV photo reactor R is used as an ashing device for removing an unnecessary photoresist on a silicon wafer or as an excimer UV-ozone cleaning device (dry cleaning device) for removing organic compound contaminants attached to the surface of a glass substrate of a liquid crystal display, the reactant gas C is ozone and the reactant gas source is an ozone generator.

When the excimer UV photo reactor R is used as a hydrogen annealing device for improving the crystal integrity of the surface of a silicon wafer by a photochemical reaction with hydrogen, the reactant gas C is hydrogen and the reactant gas source is a hydrogen cylinder.

The excimer UV photo reactor R further comprises a reaction auxiliary supply means 2 ... at a location more distant from the target article A than the reactant gas supply means 1 .... The reaction auxiliary supply means 2 ... serve to forcedly supply a reaction auxiliary gas (carrier gas) D to the target article A.

The reaction auxiliary supply means 2 in the present embodiment comprise plural introduction chambers 2a ... disposed at appropriate intervals above the parallel excimer UV lamps B ... in a staggered format with respect to the excimer UV lamps B .... These introduction chambers 2a ... have nozzles 2b ... at their bottom. The nozzles 2b ... point to passages S1 ... and passages S2 and S2. The passages S1 ... are disposed between adjacent protecting tubes B3 ..., and the passages S2 and S2 are disposed at both ends of the array of the protecting tubes B3 ....

The reaction auxiliary gas D such as nitrogen gas and inert gases (e.g., argon, helium, and others) is introduced into the introduction chamber 2a ... and is supplied as a carrier gas downward through the passages S1 ..., S2 and S2 to the reactant gas supply means 1 ....

The excimer UV photo reactor R further comprises a transport means 3 for supporting the target article A at a set distance from the parallel excimer UV lamps B ... and for relatively moving one of the excimer UV lamps B ... and the target article A while keeping the distance between the two.

The transport means 3 in the embodiment shown in the figure is a rotary transport mechanism 3a such as a rotary table and rotates to thereby move the target article A along an arc at an appropriate speed tied to the irradiation time of the excimer UV lamps B ... while the target article A is stably placed on the top of the rotary transport mechanism 3a.

The operation of the excimer UV photo reactor R will be illustrated below.

The parallel excimer UV lamps B ... radiate excimer UV toward the target article A. However, the exposure of the excimer UV is not homogenous over the entire surface of the target article A and is markedly higher in the narrow areas A1 ... directly below the excimer UV lamps B ... than in the other areas A2 ....

By introducing the reactant gas C from the reactant gas source (not shown) of the reactant gas supply means 1 ... into the gas inlet tubes 1a ... under these conditions, the reactant gas C is supplied from the nozzle orifices 1b ... of the gas inlet tubes 1a ... concentratedly to the active areas A1 ... alone irradiated with the excimer UV at a high exposure on the target article A.

The concentration of the reactant gas C in the active areas A1 was determined in an experiment and was found to be an increased concentration necessary for a stable photochemical reaction of , for example, about 1000 ppm or more.

Thus the photochemical reaction between the excimer UV and the reactant gas C is accelerated in an atmosphere at lower temperatures than those in conventional equivalents. In addition, the reactant gas C is not supplied to the areas A2 ..., where the photochemical reaction does not occur actively, and is not wasted. Accordingly, the photo reactor R does not require a reactant gas source having a large gas-supply capability.

Consequently, the photochemical reaction can be stably performed using the photo reactor with a simple structure in an atmosphere at lower temperatures.

More specifically, the excimer UV photo reactor R used as an ashing device could completely remove an unnecessary photoresist on a silicon wafer as the target article A while supplying ozone as the reactant gas C.

The excimer UV photo reactor R used as an excimer UV-ozone cleaning device (dry cleaning device) could completely remove organic compound contaminants attached to the surface of the target article A while supplying ozone as the reactant gas C.

The excimer UV photo reactor R used as a hydrogen annealing device could increase the crystal integrity of the surface of a silicon wafer as the target article A while supplying hydrogen as the reactant gas C.

In particular, the photo reactor of the present invention can be used as a resist asher that can significantly efficiently perform a reaction by having ozone discharge nozzle (nozzle orifices) 1b ... and controlling the flow rate of the nozzles. In contrast, conventionally known resist ashers using UV light for use in semiconductor manufacturing apparatus have a thick ozone layer that markedly absorbs energy of the UV light to thereby significantly reduce the reaction efficiency.

The rate of the photochemical reaction can be further increased annexing a plane heater (not shown) onto the surface on which the target article A is mounted or by applying heating radiation (not shown) to the target article A to thereby heat the target article A.

The reaction auxiliary gas D as a carrier gas such as nitrogen gas and inert gases (argon, helium, and others) is supplied downward from the nozzles 2b ... of the reaction auxiliary gas supply means 2 through the passages S1 ..., S2 and S2 to the target article A. Thus the areas A2 ... and other portions in the enclosed space S except the active areas A1 ... to which the reactant gas C is supplied are filled with the reaction auxiliary gas D to thereby exhaust unnecessary gas for the reaction from the reaction areas.

Consequently, the reactant gas C can be promptly introduced into the active areas (reaction areas) A1 ... to thereby replace the atmosphere.

In addition, the photo reactor can be prevented from filling with large amounts of the reactant gas C and can be kept safe even when the reactant gas C is a dangerous gas such as ozone or hydrogen.

The transport means 3 operates to relatively move between the excimer UV lamps B ... and the target article A and thereby allows the entire surface of the target article A to pass through positions directly below the excimer UV lamps B ....

Thus the excimer UV can be applied with a reduced variation in exposure and can be applied to the entire surface of the target article A in a shorter time.

Consequently, the photochemical reaction can be performed in a shorter time while decreasing unevenness in the reaction.

In particular, the photo reactor shown in the figure rotates and relatively moves the target article A with respect to the excimer UV lamps B ... by action of the rotary transport mechanism 3a and is capable of uniformly irradiating the entire surface of the target article A with excimer UV and is thereby capable of performing a photochemical reaction on the entire target article A without unevenness even when the target article A extends over plural adjacent excimer UV lamps B ....

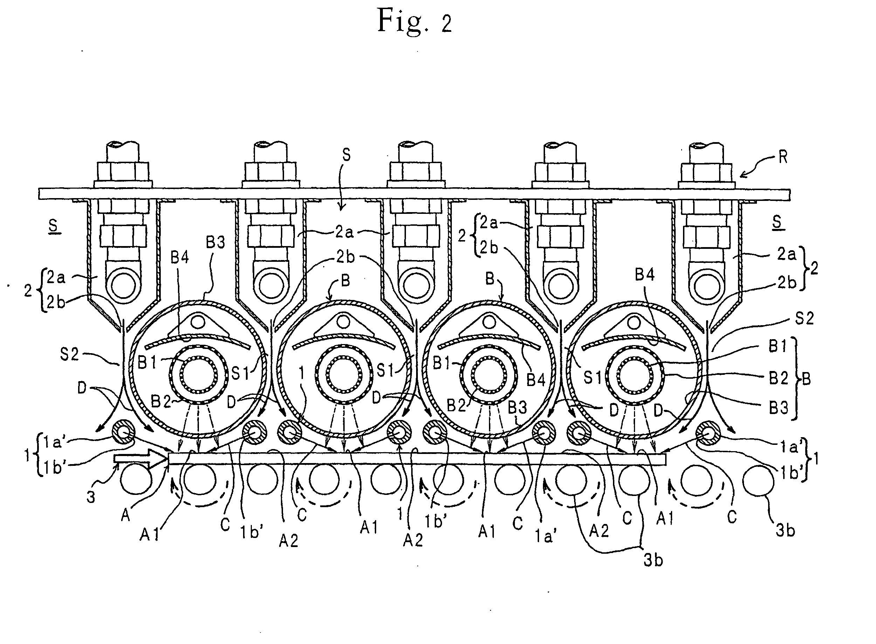

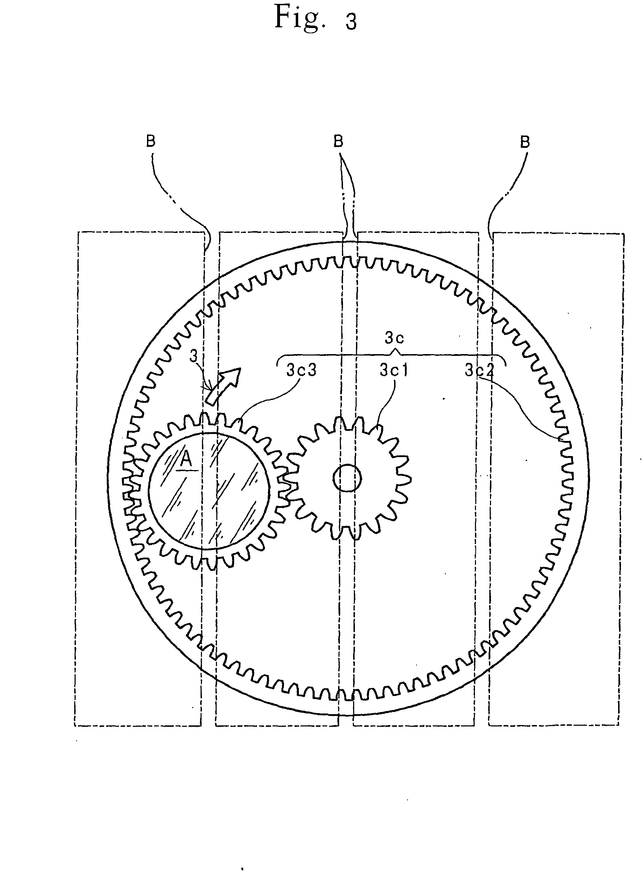

Figs. 2 and 3 illustrate modified embodiments of the present invention, respectively.

The modified embodiment shown in Fig. 2 has the same configuration as the embodiment shown in Fig. 1, except that a pair of gas inlet tubes 1a' ... of the reactant gas supply means 1 ... are disposed with each of the excimer UV lamps B ..., that each of the gas inlet tubes 1a' ... has one nozzle orifice arranged in one direction toward each active area A1 ... directly below the excimer UV lamps B ... and that the reactant gas C in each gas inlet tube 1a' is supplied as a single unit without separation.

The photo reactor shown in Fig. 2 can thereby supply the reactant gas C in a larger amount to the active areas A1 ...and can correspondingly increase the concentration of the reactant gas C than the embodiment shown in Fig. 1.

When the target article A has a large area, such as a glass substrate of a liquid crystal display, the transport means 3 preferably comprises a continuous transport mechanism 3b, such as a roller conveyor, instead of the rotary transport mechanism 3a shown in Fig. 1. The continuous transport mechanism 3b operates to transport the target article A continuously in a direction perpendicular to the axial direction of the excimer UV lamps B ... by the same distance as the pitch between the excimer UV lamps B ... or longer and thereby allows the target article A to sequentially pass through positions directly below the excimer UV lamps B ....

By allowing plural target articles A ... to pass through positions directly below the excimer UV lamps B ..., a multitude of target articles A can be continuously subjected to a photochemical reaction.

The photo reactor shown in Fig. 3 has the same configuration as the embodiments shown in Figs . 1 and 2, except that the photo reactor has a sun-and-planet motion mechanism 3c as the transport means 3 instead of the rotary transport mechanism 3a shown in Fig. 1 or the continuous transport mechanism 3b shown in Fig. 2. The sun-and-planet motion mechanism 3c comprises, for example, a sun gear 3c1 at the center, an internal gear 3c2 coaxially disposed around the sun gear 3c1, and an epicycloidal carrier 3c3. A single or plural target articles A such as semiconductor wafers are detachably held in the epicycloidal carrier 3c3. By this configuration, the epicycloidal carrier 3c3 with the target articles A revolves around the sun gear 3c1 while rotating.

By allowing the target article A to revolve while rotating, uneven irradiation due to difference in travel can be prevented, since each portion of the target article A has no difference in travel. In contrast, if the target article A is only allowed to rotate and move, a portion at the rotation axis differs in travel and thereby differs in exposure of excimer UV from a portion distant from the rotation axis to thereby cause unevenness in radiant exposure.

The photo reactor in question is specifically advantageous in cleaning of a large-diameter semiconductor wafer with excimer light, since such a large target article A often invites a difference in travel.

In the above embodiments, the excimer UV photo reactor R is used as an ashing device, an excimer UV-ozone cleaning device (dry cleaning device) or a hydrogen annealing device. The use of the photo reactor R is not specifically limited and also includes a metallorganic (MO) CVD system for the formation of a metal film on a silicon wafer by a photochemical reaction with a vaporized gas of an organometallic compound.

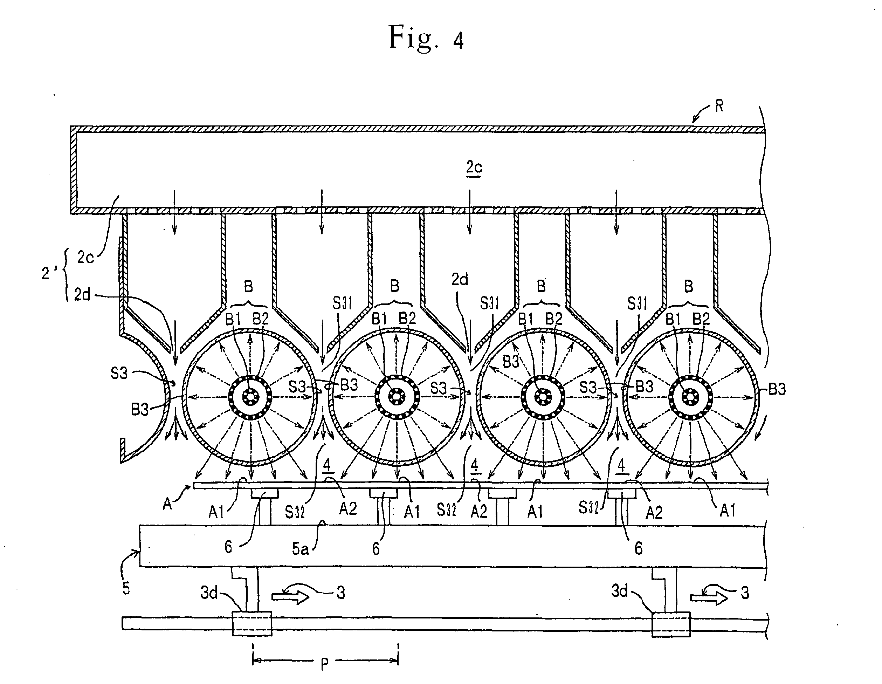

Figs. 4 to 6 illustrate an excimer UV photo reactor R as another embodiment of the present invention . In this second embodiment, the excimer UV photo reactor R is used as an excimer UV-ozone cleaning device (dry cleaning device) for oxidatively removing organic contaminants attached to the surface of the target article A such as a large-size glass substrate for use in a liquid crystal display.

In the second embodiment, a pair of optically transparent walls disposed among the excimer UV lamps B ... are cylindrical protecting tubes B3 and B3 arranged so as to surround the outer peripheries of adjacent excimer UV lamps B and B. These adjacent protecting tubes B3 ... partition and thereby constitute passages S3 with a narrowest intermediate portion in a vertical direction.

These passages S3 ... have inlets S31 ... at an upper portion distant from the target article A and outlets S32 ... at a lower portion facing the target article A. A supply means 2' is arranged on the inlets S31 ... for forcedly supplying appropriate amounts of the reaction auxiliary gas and oxygen. As the reaction auxiliary gas, a carrier gas such as nitrogen gas or an inert gas (argon, helium, and others) is supplied.

The supply means 2' in the second embodiment comprises a mixing chamber 2c, and the reaction auxiliary gas and fresh air are supplied thereinto and are mixed in set proportions. The supply means 2' also comprises nozzles 2d ... protruded from the mixing chamber 2c toward the inlets S31 ... of the passages S3 ...at appropriate intervals. The mixture of the reaction auxiliary gas and the air is blown from the nozzles 2d ... to the inlets S31 ... of the passages S3 ... to thereby supply appropriate amounts of the reaction auxiliary gas and oxygen into the passages S3 ....

By supplying appropriate amounts of the reaction auxiliary gas and oxygen into the passages S3 ..., a gas in each passage S3 is forced through the outlets S32 to the target article A and is blown into an atmosphere 4 in the vicinity of the areas A2 which are irradiated with excimer UV and are distant at a low exposure distant from the areas A1 directly below the excimer UV lamps B.

Water molecules or hydrogen is supplied in addition to the reaction auxiliary gas and oxygen.

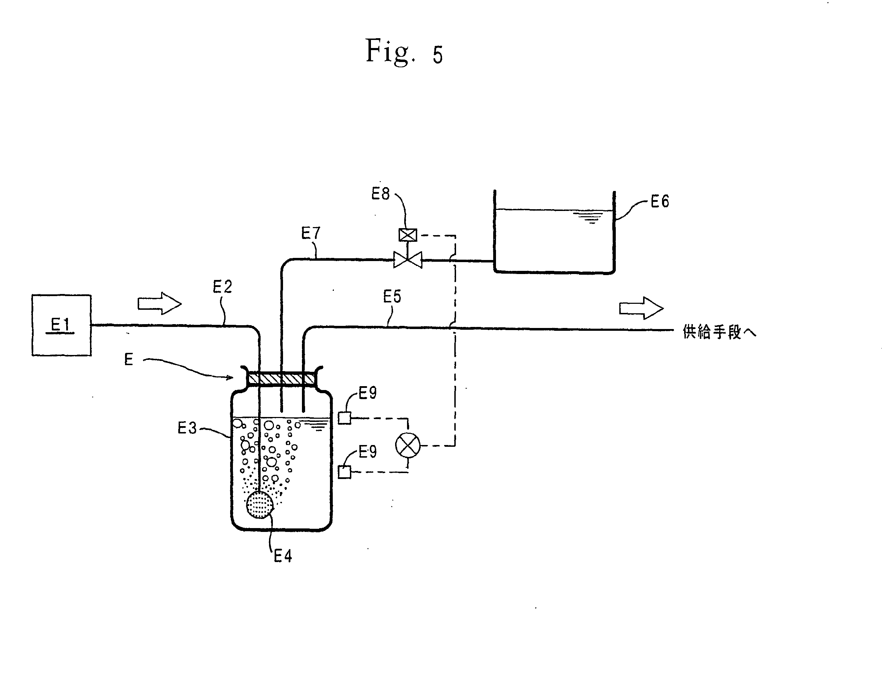

In the second embodiment, a humidifying means E shown in Fig. 5 serves to incorporate water molecules into nitrogen gas supplied as the reaction auxiliary gas (carrier gas).

The humidifying means E comprises a nitrogen gas source E1 such as a nitrogen cylinder, a feed pipe E2 connected to the nitrogen gas source E1, a gastight enclosure E3, and a conduct tube E5. The tip of the feed pipe E2 is immersed in pure water pooled in the gastight enclosure E3, and nitrogen gas bubbles up from micropores E4 formed at the tip of the feed pipe E2. The resulting humidified nitrogen gas is recovered by the conduct tube E5 and is introduced into the mixing chamber 3a of the supply means 3.

The humidifying means E further comprises a pure-water supply tank E6, a supply pipe E7 connecting between the gastight enclosure E3 and the supply tank E6, a water level regulator valve E8 at some midpoint in the supply pipe E7, and high-and low-water level sensors E9 and E9 disposed in the vicinity of the gastight enclosure E3. The humidifying means E operates and controls the water level regulator valve E8 based on signals from the water level sensors E9 and E9 so that the pure water in the gastight enclosure E3 is always held at a constant level.

The photo reactor R further comprises a transport mechanism 3d as the transport means 3 for relatively moving one of the excimer UV lamps B ... and the target article A to the other while keeping the distance therebetween constant. The transport mechanism 3d operates to transport the target article A in a direction perpendicular to the axial direction of the excimer UV lamps B ... by the same distance as a pitch P between the excimer UV lamps B ... or longer.

The photo reactor R shown in the figure also comprises a horizontal substrate 5 and plural columns protruded from the substrate 5. The target article A is held at some distance from the surface 5a of the horizontal substrate 5 by action of vacuum aspiration by the columns 6. A driving force such as a linear motor is connected to the substrate 5 and operates to linearly move the target article A together with the substrate 5 in a horizontal direction by the same distance as the pitch P at an appropriate speed tied to the irradiation time of the excimer UV lamps B ....

The photo reactor R further comprises suction means 7 and 7 around the target article A for sucking ozone and the reaction auxiliary gas from an atmosphere in the vicinity of the target article A and forcedly exhausting these gases.

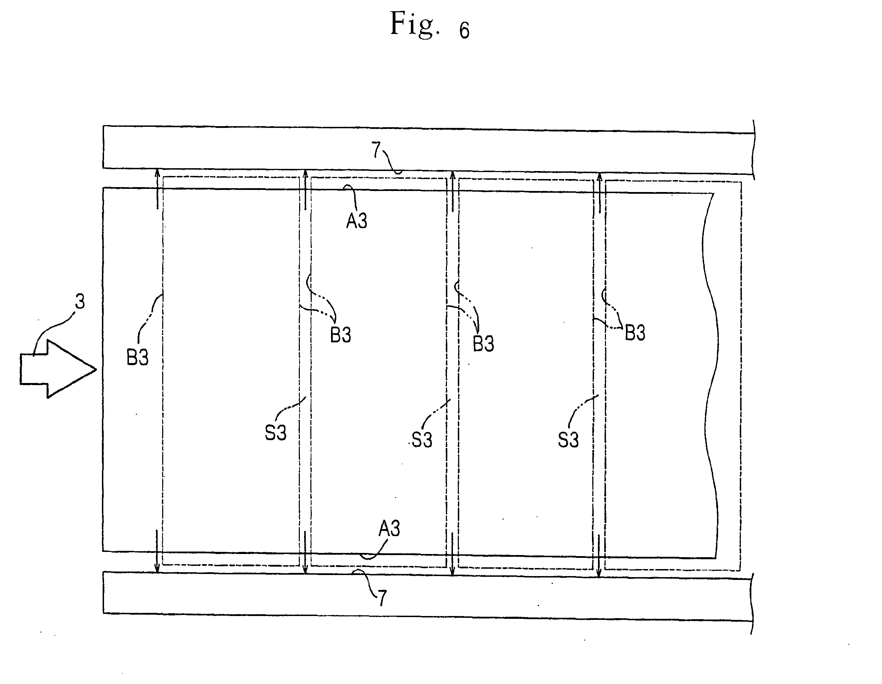

These suction means 7 and 7 are preferably disposed over the entire periphery of the target article A. It is also acceptable to dispose the suction means 7 and 7 only on both sides A3 and A3 in parallel in a direction perpendicular to the axis direction of the excimer UV lamps B ... as shown in Fig. 6.

In this case, the suction means 7 and 7 suck the ozone and the reaction auxiliary gas from a space sandwiched between the excimer UV lamps B ... and the target article A in opposite directions, respectively, perpendicular to the moving direction of the target article A by the transport means 3d. The ozone and the reaction auxiliary gas have been supplied from the outlets S32 ... of the passages S3 ....

The operation of the excimer UV-ozone cleaning device will be illustrated below.

With reference to Fig. 4, the excimer UV lamps B ... disposed in parallel emit excimer UV radially through the protecting tubes B3 ... respectively.

A part of these radiant excimer UV rays heading to the target article A serves to form ozone in a space in front of the target article A, the ozone comes into contact with the surface of the target article A to thereby oxidize and remove organic contaminants attached thereto.

In this procedure, an area A1 of the target article A directly below each excimer UV lamp B with the shortest distance from the excimer UV lamp B is irradiated with the excimer UV at a high exposure and receives light energy to a necessary quantity to thereby enable sufficient oxidation and removal of the organic contaminants. An area distant from the area A1 has a gradually increasing distance from the excimer UV lamp with an increasing distance from the area A1. Thus, the excimer UV applied to the area is absorbed by oxygen to form ozone and is thereby weakened.

Consequently, the area A2 irradiated with the excimer UV at a low exposure and distant from the area A1 directly below each excimer UV lamp B does not receive light energy to a necessary quantity to thereby fail to sufficiently oxidize and remove the organic contaminants. The area A2 is thereby cleaned to a lower degree than the area A1 directly below each excimer UV lamp B.

In other words, the degree of cleaning gradually decreases with an increasing distance from the narrow area A1 directly below each excimer UV lamp B and attains the minimum in an area corresponding to directly below the boundary between adjacent excimer UV lamps B and B.

In contrast, the excimer UV rays heading to the passage S3 between the adjacent excimer UV lamps B and B, except those emitted from the excimer UV lamps B ... heading to the target article A, pass through the protecting tubes as the optically transparent walls B3 and B3 facing each other and enter each passage S3.

The excimer UV rays passing through the optically transparent walls B3 and B3 and entering the passage S3 react with oxygen to form ozone without absorption by the reaction auxiliary gas, such as nitrogen, that has been supplied from the supply means 2' into the passage S3. The ozone increases to a high concentration during movement to the outlet S32 of the passage S3.

The resulting high-concentration ozone is forced out of the outlet S32 of each passage S3 to the target article A. Thus , an atmosphere 4 in the vicinity of the area A2 becomes rich in ozone. The area A2 is around an area directly below the outlet S32 corresponding to directly below the boundary between the excimer UV lamps B and B, is irradiated with the excimer UV at a low exposure and is distant from the area A1 directly below the excimer UV lamp B.

Thus, the area A2 irradiated with the excimer UV at a low exposure receives a sufficient quantity of light energy to oxidize and remove the organic contaminants.

Consequently, the excimer UV-ozone cleaning device can effectively utilize excimer UV rays which have not contributed to cleaning to thereby improve the cleaning efficiency and can efficiently clean the target article A even if it is a large-area article such as a glass substrate of a liquid crystal display.

When water molecules (H₂O) are supplied in addition to the reaction auxiliary gas and oxygen, the water molecules (H₂O) are further decomposed by action of the excimer UV to thereby form large amounts of [H•] radicals and [•OH] radicals. These [•OH] radicals are combined with the activated surface of the target article A after the reaction treatment with the excimer UV to further effectively modify the surfaces of the reaction areas A1 and A2 to thereby improve wettability notably.

When hydrogen (H₂) is supplied instead of the water molecules, ozone (O₃) formed by action of excimer UV and the hydrogen (H₂) are further decomposed, react with each other and thereby form large amounts of [•OH] radicals. These [•OH] radicals are combined with the activated surface of the target article A after the reaction treatment with the excimer UV to further effectively modify the surfaces of the reaction areas A1 and A2 to thereby improve wettability notably.

Consequently, activation after the reaction treatment with the excimer UV is suppressed and stabilized, thus avoiding adhesion of contaminants after the reaction treatment.

The photo reactor R of the second embodiment supplies the water molecules by humidifying the reaction auxiliary gas (nitrogen gas) itself and is thereby excellent in workability, since the photo reactor R does not cause the formation of water droplets in the reaction areas and thereby does not require extra time and effort to remove the water droplets , in contrast to a system in which water vapor is directly supplied.

In the second embodiment, the transport mechanism 3d operates to relatively move the excimer UV lamps B ... and the target article A. By setting the length of the movement at the same length as the pitch P between the excimer UV lamps B ... or longer, the entire target article A passes each of positions directly below the excimer UV lamps B ....

Thus the excimer UV can be applied with a reduced variation in exposure and can be applied to the entire surface of the target article A in a shorter time.

Consequently, the'photochemical reaction can be performed in a shorter time while avoiding uneven cleaning.

In addition, the suction means 7 and 7 operate to suck and immediately (rapidly) forcedly exhaust the ozone and the reaction auxiliary gas after cleaning (after reaction) without delay from around the target article A or from the both sides A3 and A3 facing each other as shown in Fig. 6. The ozone and the reaction auxiliary gas have contributed to oxidation and removal of the organic contaminants in an atmosphere in the vicinity of the target article A.

By this procedure, contaminant derivatives formed as a result of oxidation and removal of the organic contaminants are thereby rapidly exhausted together, and, with exhaustion, fresh ozone and reaction auxiliary gas are sequentially supplied from the outlets S32 of the passages S3 to thereby further accelerate the oxidation and removal of the organic contaminants.

The cleaning efficiency can therefore be further improved while preventing the contaminants formed with the cleaning from adhering to the protecting tubes B3 ... and surroundings thereof.

The protecting tubes B3 covering the outer peripheries of the individual excimer UV lamps B can prevent the target article A from coming in direct contact with the inner electrodes B1 and the outer electrodes B2 of the excimer UV lamps B. The nitrogen gas supplied into the protecting tubes B3 can prevent the inner electrodes B1 and the outer electrodes B2 from coming in direct contact with activated oxygen and thereby from forming oxides and can prevent the excimer UV from absorbing in a space between the tube wall (outer electrode B2) of the lamp B and the outside of the protecting tube B3 to thereby prevent light intensity from decreasing.

Consequently, the device can keep an appropriate distance between the electrodes of the excimer UV lamp B and the target article while protecting the electrodes and can reduce its production cost even when the target article A is a large-area article such as a glass substrate of a liquid crystal display.

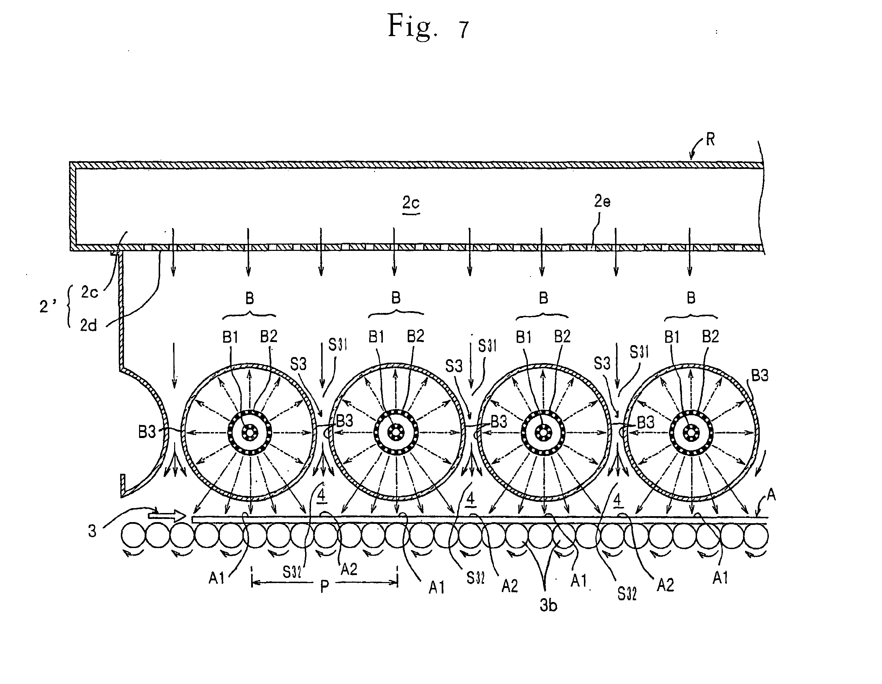

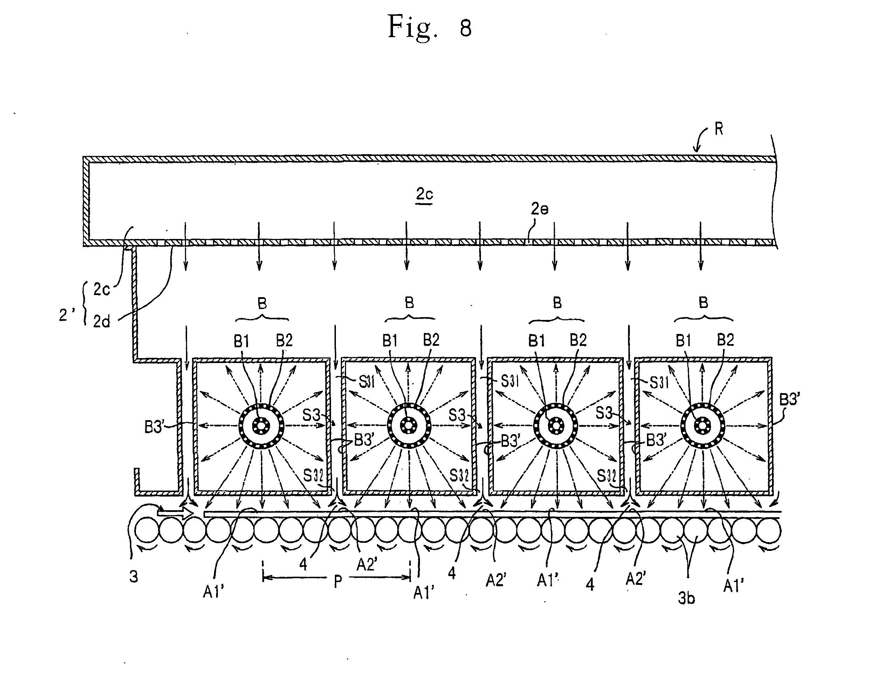

Figs. 7 and 8 respectively illustrate modified embodiments of the present invention.

The modified embodiment shown in Fig. 7 has the same configuration as the second embodiment shown in Figs. 4 to 6, except that the supply means 2' has a perforated plate 2e made of, for example, punching metal instead of the nozzles 2d ... and forcedly supplies appropriate amounts of the reaction auxiliary gas and oxygen from the mixing chamber 2c through the perforated plate 2e to the inlets S31 ... of the passages S3 ....

Accordingly, the device shown in Fig. 7 can have the supply means 2' with a simple configuration and thereby reduce its production cost.

The modified embodiment shown in Fig. 8 has the same configuration as the second embodiment shown in Figs. 4 to 6, except that the optically transparent walls B3 and B3 are square-tubular protecting tubes surrounding the outer peripheries of the adjacent excimer UV lamps B and B and that the adjacent vertical protecting tubes B3 and B3 partition and constitute each passage S3 with the same width through its length in a vertical direction.

Thus the device shown in Fig. 8 enables the excimer UV emitted from the inner electrode B1 and the outer electrode B2 to reach the outside of the protecting tube B3 without absorption by supplying nitrogen gas into between each excimer UV lamp B and the square-tubular protecting tube B3 as in the embodiment shown in Figs. 4 to 6. In addition, the distance between the flat bottom of the square-tubular protecting tube B3 and the target article A can be uniformized.

Consequently, any portion in an area A1' in the target article A in parallel with the flat bottom of the square-tubular protecting tube B3 is irradiated with the excimer UV at a high exposure and thereby receives sufficient light energy to oxidize and remove the organic contaminants satisfactorily. The other area A2' irradiated with the excimer UV at a low exposure than the area A1' has an area much smaller than that in the embodiment shown in Fig. 1. In addition, the atmosphere 4 around the area A2' becomes rich in ozone to thereby further improve the cleaning efficiency.

The devices shown in Figs. 7 and 8 have a continuous transport mechanism 3b such as a roller conveyor as the transport means 3 for the target article A. The transport means 3 is not specifically limited to the continuous transport mechanism 3b and also includes the rotary transport mechanism 3a shown in Fig. 1, the sun-and-planet motion mechanism 3c shown in Fig. 3, and the transport mechanism 3d shown in Fig. 4.

The above embodiments and modified embodiments are illustrated by taking excimer UV lamps B having a dual cylindrical structure comprising the mesh cylindrical inner electrode B1 and outer electrode B2 arrayed coaxially as an example. However, the structure of the excimer UV lamps B is not specifically limited as long as it can radiantly emit excimer UV. The transparent protecting tube B3 covering the outside thereof can be a polygonal tube as well as the cylindrical or the square tube shown in Fig. 8.

The pair of optically transparent walls B3 and B3 disposed between the excimer UV lamps B ... have been illustrated by taking cylindrical or square-tubular protecting tubes surrounding the outer peripheries of the adjacent excimer UV lamps B and B as an example. The optically transparent walls B3 are not specifically limited to such tubular protecting tubes and can be non-tubular optically transparent walls partitioning the exposed outer electrodes A2.

### Industrial Applicability

As is described above, the photo reactor of the invention according to claim 1 of the present invention supplies the reactant gas from the reactant gas supply means concentratedly to the active areas alone on the target article. Thus, the photo reactor can accelerate the photochemical reaction between excimer UV and the reactant gas in a low-temperature atmosphere. The reactant gas is not supplied to areas, where the photochemical reaction does not actively occur, and is not wasted. The photo reactor thereby does not require a reactant gas source having a large gas-supply capability and can stably perform the photochemical reaction with a simple structure in a low-temperature atmosphere.

Accordingly, the photo reactor can efficiently perform photochemical reactions and is highly cost effective.

In addition to the advantages of the invention according to claim 1, the device of the invention according to claim 2 can promptly introduce a reactant gas into active areas (reaction areas) to thereby replace the atmosphere, since a space except the active areas to which the reactant gas is supplied is filled with the reaction auxiliary gas and that an unnecessary gas in the reaction is rapidly exhausted from the reaction areas.

The advantages of the invention according to claim 3 are as follows. The excimer UV is applied from the excimer UV lamps through the optically transparent walls into the passages and reacts with oxygen to form ozone without being absorbed by the reaction auxiliary gas in the passages. The ozone increases to a high concentration during its moving to outlets of the passages and is forced through the outlets to the target article so that an atmosphere becomes rich in ozone, which atmosphere is in the vicinity of areas which are irradiated with the excimer UV at a low exposure and distant from areas directly below the excimer UV lamps . Thus the areas in question receive a sufficient quantity of light energy to oxidize and remove organic contaminants to thereby effectively use excimer UV which has not contributed to cleaning to thereby improve the cleaning efficiency.

The photo reactor can thereby efficiently clean even a large-area target article such as a glass substrate of a liquid crystal display as compared with conventional equivalents which show apparent differences in degree of cleaning between areas directly below individual excimer UV lamps and areas distant therefrom.

The invention according to claim 4 has the following advantages in addition to the advantages of the invention according to claim 3. The ozone (O₃) formed by action of the excimer UV and water molecules (H₂O) or hydrogen (H₂) are further decomposed, react with each other and thereby form large amounts of [•OH] radicals. These [•OH] radicals are combined with the activated surface of the target article after the reaction treatment with the excimer UV to further effectively modify the surface of the reaction area to thereby improve wettability. Consequently, activation after the reaction treatment with the excimer UV is suppressed and stabilized, thus avoiding adhesion of contaminants after the reaction treatment.

The photo reactor can thereby further accelerate oxidation and removal of the organic contaminants.

The invention according to claim 5 has the following advantages in addition to the advantages of the invention according to any one of claims 1, 2, 3, and 4. By covering the outer peripheries of the excimer UV lamps with the protecting tubes, the electrodes of the excimer UV lamps are prevented from coming in direct contact with activated oxygen and from forming oxides. In addition, the excimer UV is prevented from being absorbed by a space between the tube walls of the lamps B(outer electrode B2) to the outside of the protecting tubes B3 to thereby prevent the light intensity from decreasing. Thus an appropriate distance between the electrodes of the excimer UV lamps and the target article can be kept while protecting the electrodes.

Accordingly, the photo reactor can reduce its production cost even when the target article is a large-area article such as a glass substrate of a liquid crystal display as compared with conventional equivalents that require an upsized synthetic quartz glass for the output window with an increasing size of the target article.

The invention according to claim 6 has the following advantages in addition to the advantages of the invention according to claim 5. The ozone and the reaction auxiliary gas after cleaning which have contributed to oxidation and removal of organic contaminants are aspirated from an atmosphere in the vicinity of the target article and are forcedly exhausted without delay. Contaminants formed as a result of the oxidation and removal of the organic contaminants are thereby rapidly exhausted together, and fresh ozone and reaction auxiliary gas are sequentially supplied from the outlets of the passages along with the exhaustion to thereby further enhance the oxidation and removal of the organic contaminants. Thus, the cleaning efficiency can be further improved while preventing the attachment of contaminants formed with cleaning procedure to the protecting tubes or to the surroundings thereof.

In addition to the advantages of the invention according to any one of claims 1, 2, 3, and 4, the device of the invention according to claim 7 can shorten a reaction time while avoiding unevenness in the photochemical reaction. By relatively moving the excimer UV lamps and the target article, the entire target article passes through positions directly below the excimer UV lamps. Unevenness in exposure of the excimer UV is thereby minimized, and the irradiation time of the excimer UV to irradiate the entire surface of the target article is shortened.

## Claims

1. An excimer UV photo reactor comprising plural excimer UV lamps (B) and being capable of applying excimer UV from these excimer UV lamps (B) to a target article (A) in an atmosphere of a reactant gas (C) to thereby allow a photochemical reaction to occur on a surface of the target article (A), the plural excimer UV lamps (B) being arrayed in parallel and facing the target article (A),
wherein the excimer UV photo reactor further comprises reactant gas supply means (1) in the vicinity of the surface of the target article (A) , the reactant gas supply means (1) being capable of forcedly supplying the reactant gas (C) to active areas (A1) on the target article (A) , the active areas (A1) being irradiated with the excimer UV at a high exposure.

2. The excimer UV photo reactor according to claim 1, further comprising reaction auxiliary gas supply means (2) being arranged more distant from the target article (A) than the reactant gas supply means (1) and being capable of forcedly supplying a reaction auxiliary gas (D) to the target article (A).

3. An excimer UV photo reactor comprising plural excimer UV lamps (B) and being capable of applying excimer UV from these excimer UV lamps (B) to a target article (A) to form ozone to thereby oxidize and remove organic contaminants attached to a surface of the target article (A) , the plural excimer UV lamps (B) being arrayed in parallel and facing the target article (A),
wherein the excimer UV photo reactor further comprises pairs of optically transparent walls (B3) being highly transparent to the excimer UV, each pair of optically transparent walls (B3) being sandwiched between two of excimer UV lamps (B) and partitioning and constituting a passage (S3), wherein the excimer UV photo reactor further comprises supply means (2') at an inlet (S31) of each passage (S3) , the supply means (2') being capable of forcedly supplying appropriate amounts of a reaction auxiliary gas and oxygen, and wherein the excimer UV photo reactor is capable of forcing ozone formed in each passage (S3) from an outlet (S32) thereof to the target article (A) so that an atmosphere (4) becomes rich in ozone, the atmosphere (4) being in the vicinity of areas (A2) being irradiated with the excimer UV at a low exposure and being distant from areas (A1) directly below the excimer UV lamps (B) .

4. The excimer UV photo reactor according to claim 3, further comprising humidifying means (E) for supplying water molecules or hydrogen in addition to the reaction auxiliary gas and oxygen.

5. The excimer UV photo reactor according to any one of claims 1, 2, 3 and 4 , wherein each of the optically transparent walls (B3) is a protecting tube surrounding outer periphery of each excimer UV lamp (B) , and wherein nitrogen gas is supplied into between the excimer UV lamp (B) and the protecting tube (B3).

6. The excimer UV photo reactor according to claim 5, further comprising suction means (7) for sucking the ozone and the reaction auxiliary gas from an atmosphere in the vicinity of the target article (A) and forcedly exhausting the gases.

7. The excimer UV photo reactor according to any one of claims 1, 2, 3, and 4, further comprising transport means (3) for relatively moving one of the excimer UV lamps (B) and the target article (A) to the other while maintaining the distance between the two.

## Amended claims

### Amended claims under Art. 19.1 PCT

**1.** An excimer UV photo reactor comprising plural excimer UV lamps (B) and being capable of applying excimer UV from these excimer UV lamps (B) to a target article (A) in an atmosphere of a reactant gas (C) to thereby allow a photochemical reaction to occur on a surface of the target article (A), the plural excimer UV lamps (B) being arrayed in parallel and facing the target article (A),
wherein the excimer UV photo reactor further comprises reactant gas supply means (1) in the vicinity of the surface of the target article (A) , the reactant gas supply means (1) being capable of forcedly supplying the reactant gas (C) to active areas (A1) on the target article (A) , the active areas (A1) being irradiated with the excimer UV at a high exposure, wherein the excimer UV photo reactor further comprises transparent protecting tubes (B3) , each of the protecting tubes (B3) surrounding each of the excimer UV lamps (B) , and wherein nitrogen gas is supplied into between the excimer UV lamp (B) and the protecting tube (B3).

**2.** The excimer UV photo reactor according to claim 1, further comprising reaction auxiliary gas supply means (2) being arranged more distant from the target article (A) than the reactant gas supply means (1) and being capable of forcedly supplying a reaction auxiliary gas (D) to the target article (A).

**3.** An excimer UV photo reactor comprising plural excimer UV lamps (B) and being capable of applying excimer UV from these excimer UV lamps (B) to a target article (A) to form ozone to thereby oxidize and remove organic contaminants attached to a surface of the target article (A) , the plural excimer UV lamps (B) being arrayed in parallel and facing the target article (A),
wherein the excimer UV photo reactor further comprises pairs of optically transparent walls (B3) being highly transparent to the excimer UV, each pair of optically transparent walls (B3) being sandwiched between two of excimer UV lamps (B) and partitioning and constituting a passage (S3) , wherein the excimer UV photo reactor further comprises supply means (2') at an inlet (S31) of each passage (S3) , the supply means (2') being capable of forcedly supplying appropriate amounts of a reaction auxiliary gas and oxygen, and wherein the excimer UV photo reactor is capable of forcing ozone formed in each passage (S3) from an outlet (S32) thereof to the target article (A) so that an atmosphere (4) becomes rich in ozone, the atmosphere (4) being in the vicinity of areas (A2) being irradiated with the excimer UV at a low exposure and being distant from areas (A1) directly below the excimer UV lamps (B).

**4.** The excimer UV photo reactor according to claim 3, further comprising humidifying means (E) for supplying water molecules or hydrogen in addition to the reaction auxiliary gas and oxygen.

**5.** The excimer UV photo reactor according to one of claims 3 and 4 , wherein each of the optically transparent walls (B3) is a protecting tube surrounding outer periphery of each excimer UV lamp (B) , and wherein nitrogen gas is supplied into between the excimer UV lamp (B) and the protecting tube (B3) .

**6.** The excimer UV photo reactor according to claim 5, further comprising suction means (7) for sucking the ozone and the reaction auxiliary gas from an atmosphere in the vicinity of the target article (A) and forcedly exhausting the gases.

**7.** The excimer UV photo reactor according to any one of claims 1, 2, 3, and 4, further comprising transport means (3) for relatively moving one of the excimer UV lamps (B) and the target article (A) to the other while maintaining the distance between the two.

Statement under Art. 19.1 PCT
Claim 1 is amended and clarified to limit to "wherein the excimer UV photo reactor further comprises transparent protecting tubes (B3), each of the protecting tubes (B3) surrounding each of the excimer UV lamps (B), and wherein nitrogen gas is supplied into between the excimer UV lamp (B) and the protecting tube (B3)".

Cited references fail to disclose a configuration in which the outside of an excimer UV lamp is covered with a transparent protecting tube.

The invention according to claim 1 can show the same advantages as the invention according to claim 5.

Claims 1 and 2 are deleted from claims on-which claim 5 depends.
